# EUROPÄISCHE PATENTSCHRIFT

(11) **EP 0 602 102 B1**
(45) Veröffentlichungstag und Bekanntmachung des Hinweises auf die Patenterteilung: **13.03.1996**
(21) Anmeldenummer: 92918369.7
(22) Anmeldetag: 27.08.1992
(51) Int. Cl.: H05K 13/00

(54) **BANDFÖRMIGER HILFSTRÄGER ALS MONTAGEHILFE FÜR DIE ZEILENWEISE MONTAGE VON HALBLEITERCHIPS AUF EINER PA FLÄCHE EINES TRÄGERELEMENTES**
STRIP-SHAPED AUXILIARY SUPPORT AS A FITTING AID FOR THE LINEWISE ASSEMBLY OF SEMICONDUCTOR CHIPS ON A LOCATING SURFACE OF A SUBSTRATE
SUPPORT AUXILIAIRE EN FORME DE BANDE SERVANT D'AIDE POUR LE MONTAGE LIGNE PAR LIGNE DE PUCES A SEMICONDUCTEUR SUR LA SURFACE DE CONTACT D'UN ELEMENT PORTEUR

(30) Priorität: 02.09.1991 DE 4129146
(43) Veröffentlichungstag der Anmeldung: 22.06.1994
(73) Patentinhaber: Siemens Nixdorf Informationssysteme Aktiengesellschaft, D-33102 Paderborn (DE)
(72) Erfinder: FRÖHLICH, Georg, D-85521 Riemerling (DE); SCHREYER, Siegfried, D-85625 Glonn (DE)
(74) Vertreter: Fuchs, Franz-Josef, Dr.-Ing.
(86) Internationale Anmeldenummer: DE9200715
(87) Internationale Veröffentlichungsnummer: WO9305636

(56) Entgegenhaltungen:
- EP-A- 0 389 826
- EP-A- 0 415 663
- EP-A- 0 422 828
- WO-A-89/08927
- US-A- 4 566 170

## Beschreibung

Bandförmiger Hilfsträger als Montagehilfe für die zeilenweise Montage von Halbleiterchips auf einer Paßfläche eines Trägerelementes

Die Erfindung betrifft einen bandförmigen Hilfsträger als Montagehilfe für die zeilenweise Montage von Halbleiterchips auf einer Paßfläche eines Trägerelementes, insbesondere zur Herstellung von Zeichengeneratoren für nach dem Umdruckverfahren arbeitende Drucker oder Kopierer oder zur Herstellung von Scannern bzw. Thermorkämmen sowie ein Verfahren zur zeilenweisen Montage der Halbleiterchips auf der Paßfläche des Trägerelementes sowie eine Anordnung zum Befestigen der Halbleiterchips auf dem Hilfsträger.

Bei modernen elektrofotografischen Druckern oder Kopierern werden als Belichtungseinrichtungen zur Erzeugung eines latenten Zeichenbildes auf dem Fotoleiter LED-Zeichengeneratoren verwendet, bei denen auf einem Trägerelement eine Vielzahl von Leuchtdiodenchips mit zugehörigen Ansteuereinrichtungen angeordnet sind.

Zur Befestigung der Chips auf dem Trägerelement ist es aus der US-A-4,566,170 bekannt, die einzelnen, Leuchtdioden aufweisenden Chips, zunächst auf einzelnen kleinen Kupferträgern, sogenannten Minimodulträgern, festzukleben. In einem weiteren Schritt werden dann die so gebildeten Minimodule über die Minimodulträger auf ein gemeinsames Substrat aus Keramik geklebt. Danach wird das Substrat mit den darauf angeordneten Minimodulen auf einem Kühlblock befestigt.

Ein ähnliches Montageverfahren wird in der WO 89/08927 beschrieben.

Bei moderneren Zeichengeneratoren erfolgt die Befestigung der Minimodule unter Weglassung des Substrats unmittelbar auf einer Paßfläche eines als Kühlelemente dienenden Trägerelementes. Befestigt wird der Minimodulträger auf dem Trägerelement durch Löten, um die beim Betrieb der LED-Chips entstehende Wärme leicht ableiten zu können.

Ein derartiges Fertigungsverfahren ist insbesondere dann aufwendig und fehleranfällig, wenn auf diese Weise Zeichengeneratoren für elektrofotografische Drucker z. B. mit hoher Auflösung von z. B. 600 dpi (Zeichenpunkte pro Inch und mehr) erzeugt werden. Bei derartigen Zeichengeneratoren mit mehreren tausend Leuchtelementen sind auf dem Trägerelement eine Vielzahl von Chips nebeneinander angeordnet. Dabei ist zur Erzeugung eines fehlerfreien Zeichenbildes eine exakte punktgenaue Positionierung der Chips von wenigen pm in absoluter Genauigkeit plaziert, nebeneinander erforderlich.

Die bekannten Fertigungsverfahren zur Herstellung derartiger Zeichengeneratoren sind aufwendig und fehleranfällig und meist zu ungenau. Durch die großen Massen und ihre Unterschiede, z. B. zwischen den kleinen Minimodulträgern und den großen Trägerelementen, sind komplexe Lötvorrichtungen oder Klebevorrichtungen mit vielen Zwischenschritten erforderlich, welche wiederum eine Lötung in einer Dampfphasenlötanlage oder Ofen und eine komplexe Reinigungstechnik erforderlich machen. Der erforderliche technische Aufwand zum anschließenden Bonden und Prüfen sowie weiterer Montagen der auf dem Trägerelement angeordneten Minimodule ist sehr umfangreich und kostenintensiv.

Zur exakten Positionierung der Minimodule auf dem Trägerelement ist es notwendig, diese einzeln nacheinander auf dem z. B. als Kühlelement dienenden Trägerelement zu befestigen. Dieses Einzelhandling der Minimodule erfordert einen erheblichen Dispositions-Selektions-Handlings- und gegebenenfalls Sortieraufwand, d. h. einen erheblichen Aufwand in Logistik, Vorrichtungsbau sowie einen Magazinier- und Automatenaufwand. Eine automatische Fertigung von derartigen Zeichengeneratoren wird dadurch wesentlich erschwert.

Werden die einzeln gefertigten Minimodule nebeneinander auf dem Trägerelement angeordnet, besteht die Gefahr, daß sich die Fehlertoleranzen der einzelnen Minimodule aufsummieren. Um dies zu verhindern, ist ein aufwendiges Meß- und Prüfverfahren sowie Regelungstechnik der einzelnen Minimodule vor ihrer Montage und Fixierung notwendig.

Die beschriebenen Probleme treten auch auf bei der Herstellung von Abtastkämmen für Abtasteinrichtungen, sogenannten Scannern, bei der die einzelnen nebeneinander angeordneten Halbleiterchips Fototransistoren als Empfangselemente aufweisen und bei denen wie bei Zeichengeneratoren Temperatureinflüsse eine wesentliche Rolle spielen. Ähnliches gilt für Thermokämme in Thermodruckeinrichtungen, bei denen die Halbleiterchips, die ebenfalls nebeneinander angeordnet sind, Thermoelemente aufweisen.

Aufgabe der Erfindung ist es deshalb, eine Einrichtung und ein Verfahren für die zeilenweise Montage von Halbleiterchips auf einer Paßfläche eines Trägerelementes bereitzustellen, die eine automatengerechte, paßgenaue Montage ermöglicht. Die Temperaturabhängigkeit bei der Montage soll sich nicht negativ auf die Positionierungsgenauigkeit auswirken.

Die Befestigung des Halbleiterchips soll so ausgestaltet sein, daß die beim Betrieb des Halbleiterchips entstehende Wärme ohne Wärmestau in den Verbindungsflächen von Halbleiterelementen zum Kühlträger abgeführt werden kann.

Das Ziel der Erfindung wird durch die Merkmale der Hauptansprüche erreicht. Vorteilhafte Ausführungsformen der Erfindung sind durch die Merkmale der Unteransprüche gekennzeichnet.

Die Verwendung von einem bandförmigen Hilfsträger mit darauf angeordneten Minimodulträgern, die relativ zum Hilfsträger allseitig auslenkbar angeordnet sind und die eine sich an der Gestaltung der Paßfläche des Trägerelementes orientierende Montagefläche und eine der Montagefläche gegenüberliegende Aufnahmefläche zur Aufnahme der Chips aufweisen, ermöglicht eine paßgenaue und automatengerechte Montage unter Berücksichtigung der thermischen Verhältnisse in der Verbindungstechnologie. Dadurch ist es möglich, die einzelnen Halbleiterchips auf dem Hilfsträger zu installieren, komplett zu prüfen und eventuell fehlerhafte Chips zu kennzeichnen. Sämtliche Chips für ein Hilfsträgerelement, welches die Module für die Vormontage der Halbleiterchips beinhaltet, werden gemäß einer Ausführungsform gegurtet auf dem Band angeordnet und zwar in der geordneten Reihenfolge ihrer Position auf dem Hilfsträgerelement, was die spätere Montage auf dem Kühlträgerelement wesentlich erleichtert. Die Montageflächen der Minimodulträger sind dabei exakt den Paßflächen des Kühlträgerelementes angepaßt, was eine toleranzarme Positionierung der gesamten Minimodule in Z-Richtung ohne zusätzlichen Prüfaufwand auf dem Kühlträgerelement ermöglicht. Eine Prüfung auf Paßgenauigkeit und Funktionstüchtigkeit der Minimodule mit den darauf angeordneten Halbleiterchips kann unmittelbar nach der Montage der Halbleiterchips auf dem Hilfsträgerband ggf. nach weiteren Fertigungsschritten, wie z. B. Bonden, erfolgen. Dies reduziert den Prüfaufwand beim Hersteller der angesprochenen Aggregate, d. h. beim Hersteller von Zeichengeneratoren, Scannern oder Thermokämmen erheblich.

Durch die kardanische bzw. mäanderförmige Aufhängung der Minimodule auf dem Hilfsträger ist gemäß einer weiteren Ausführungsform eine spannungsfreie und exakte Positionierung und Befestigung der Minimodule in den Fertigungseinrichtungen der weiterverarbeitenden Anlagen möglich. Die in Bandform im Hilfsträger angeordneten Minimodule und damit positionsgenau gehalten, gestatten insbesondere eine sehr wirtschaftliche Montage der Halbleiterchips durch Löten oder Kleben mit höchster Präzision bei der Montage. Die thermischen Einflüsse auf die Positionierung der Halbleiterchips auf den Minimodulen können hiermit gerade beim Löten durch das eine spätere gute Wärmeabteilung beim Betreiben der Halbleiterchips ermöglicht wird, weitestgehend reduziert werden.

Hierzu kann eine der Montagefläche zugeordnete galvanotechnische Beschichtung von Vorteil sein und kann derart ausgestaltet sein, daß nach der Befestigung der Montagefläche auf der Paßfläche des Trägerelementes im Minimodulträger ein Bimetalleffekt auftritt, der bei Erwärmung einen sich verstärkenden spezifischen Flächendruck im Befestigungsbereich des Halbleiterchips bewirkt, so daß sich der Minimodulträger flächig an das Kühlträgerelement anliegt und so ein guter Wärmeübergang gewährleistet ist.

Zum Befestigen der Halbleiterchips auf dem Minimodulträger des Hilfsträgers wird bei einer vorteilhaften Ausführungsform der Erfindung der Minimodulträger während des Verbindungsvorganges mit seiner Montagefläche bei der Montage an einer Stützfläche im Greiferelement zur Anlage gebracht, um die die erforderliche Höhentoleranz des Chips zum Modulträger für eine eng tolerierte Verbindung (Lot oder Klebstoff) zu erreichen, diese Stützfläche in einem Greifer- oder Positionierungselement für die Chips hat ihr Gegenstück auf dem Minimodul durch besondere präzise Gestaltung der Minimoduloberfläche. Danach wird über ein Zuführelement das Halbleiterchip in einem sich an der Stützfläche orientierenden Abstand gegenüber dem Minimodulträger positioniert und zwar derart, daß sich zwischen dem Chip und dem Minimodulträger ein Spalt zur Aufnahme eines Verbindungswerkstoffes bildet. Durch den Minimodulträger hindurch wird dann in dem Spalt der Verbindungswerkstoff zugeführt oder er ist bereits Im Spalt vorpositioniert, so daß er während des Verbindungsprozesses mit den Montageflächen diese benetzt und sich verteilt. Danach verfestigt sich das Lot bzw. der Klebstoff härtet aus.

Durch diese Montage ergibt sich ein exakter Abstand zwischen Stützfläche und Oberfläche des Chips, wobei Höhentoleranzen des Chips bei der Montage ausgeglichen werden. Auf diese Weise ist eine exakte Positionierung der Halbleiterchips mit den zugehörigen Modulträgern auf dem Kühlträgerelement bei der späteren Zeilenanordnung in einer definierten Funktionsebene eng toleriert möglich. Dies ist besonders wichtig bei der Herstellung von Zeichengeneratoren für nichtmechanische Druckeinrichtungen, bei denen ein konstanter Abstand zwischen den abstrahlenden LED's und dem Fotoleiter über die gesamte Breite des Zeichengenerators gewährleistet sein muß.

Die Beachtung eines definierten Abstandes der Funktionsfläche der Halbleiterelemente zur Modulplattenpaßfläche zur Aufnahme des Verbindungswerkstoffes garantiert außerdem eine lunkerfreie Verbindung ohne Hohlräume bzw. verbindungswerkstoffreie Bereiche. Dies wiederum garantiert eine wärmestaufreie Wärmeabfuhr bis hin zum Kühlträgerelement.

Ausführungsformen der Erfindung sind in den Zeichnungen dargestellt und werden im folgenden anhand der Zeichnungen beispielsweise näher beschrieben. Es zeigen
Figur 1 eine schematische Schnittdarstellung eines Zeichengenerators für eine elektrofotografische Druckeinrichtung,
Figur 2 eine schematische Darstellung eines bandförmigen Hilfsträgers mit darauf angeordneten Minimodulen in kardanischer Aufhängung,
Figur 3 eine schematische Darstellung eines bandförmigen Hilfsträgers mit darauf angeordneten Minimodulen in mäanderförmiger Aufhängung,
Figur 4 eine schematische Darstellung einer Bestückungseinrichtung zur Befestigung von Halbleiterchips auf Minimodulträgern eines bandförmigen Hilfsträgers in face-down Technik,
Figur 5 eine schematische Darstellung einer toleranzausgleichenden Anordnung zur Positionierung der Halbleiterchips beim Verbindungsvorgang,
Figur 6 - Figur 8 eine schematische Darstellung einer Bestückungseinrichtung für einen Zeichengenerator und
Figur 9 eine schematische Darstellung des Aufbaues eines Minimodulträgers.

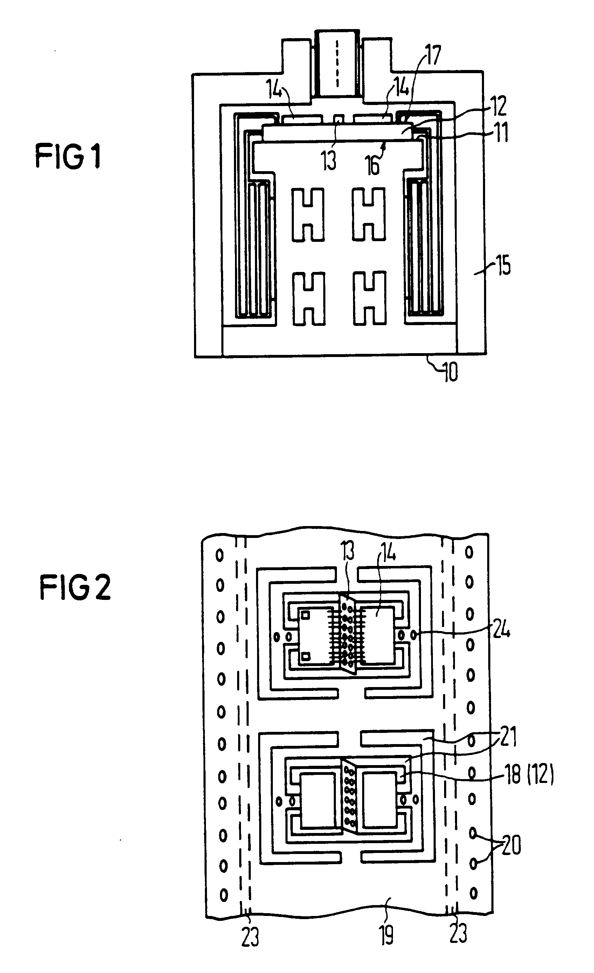

Ein in der Figur 1 schematisch im Querschnitt dargestellter Zeichengenerator dient zur Erzeugung von latenten Zeichenbildern auf einem Fotoleiter einer elektrofotografischen Druckeinrichtung. Er enthält im wesentlichen ein massives Trägerelement 10 aus Kupfer mit darauf angeordneter, hochgenau bearbeiteter Paßfläche 11 zur Aufnahme von einzelnen nebeneinander angeordneten Minimodulen. Die Minimodule wiederum enthalten jeweils einen Minimodulträger 12, beispielsweise aus einem dünnen Kupferplättchen, mit darauf befestigtem LED-Halbleiterchip 13 mit zugehörigen integrierten Ansteuerschaltkreisen 14. Das Minimodul ist bei dem dargestellten Ausführungsbeispiel auf der Paßfläche des Trägerelementes 10 aufgelötet, um einen sicheren Wärmeübergang zwischen dem Minimodul und dem als Kühl- und Positionierelement dienenden Trägerelement 10 zu gewährleisten. Der Zeichengenerator ist in einem Gehäuse 15 angeordnet und weist gegenüber den LED-Halbleiterchips 13 angeordnete SELFOC-Linsen auf, die dazu dienen, die LED-Leuchtpunkte auf einem Fotoleiter abzubilden.

Bei dem dargestellten Ausführungsbeispiel der Figur 1 ist das Minimodul über den Minimodulträger 12 unmittelbar auf der Paßfläche 11 des Trägerelementes 10 befestigt. Bei der Herstellung von Hochleistungszeichengeneratoren mit besonders engen Positionstoleranzen der LED-Chips ist es jedoch günstig, zunächst die Minimodule auf einem gesonderten bandförmigen Trägerelement anzuordnen, um eine gute Vorpositionierung der Chips auf den Minimodulen und im Folgeschritt dann auf dem Kühlträger 10 zu erreichen. Nach dem Herauslösen der Minimodule aus ihrer mäanderförmigen oder kardanisch ausgebildeten Aufhängung im Hilfsträgerband und nach der Bestückung mit IC's, der Bondung sowie Vorprüfung werden sie auf dem Kühlträger toleranzgenau entsprechend den Funktionstoleranzen im Halbleiterelement (LED-Chip) montiert.

Zu diesem Zweck muß auf die Unterseite der Minimodule bzw. auf deren Paßfläche zum Kühlträger bereits bei der Gestaltung der Oberfläche des Hilfsträgerbandes funktional Einfluß genommen werden. Dadurch ist eine hochgenaue und luftspaltfreie Positionierung möglich.

Zur Befestigung des LED-Chips und damit des Minimoduls über den Minimodulträger 12 auf den Paßflächen 11, des z. B. als Kühlelement ausgebildeten Trägerelementes 10, weist jeder Minimodulträger 12 an seiner Unterseite eine sich an der Gestaltung der Paßflächen 11 des Trägerelementes 10 orientierende Montagefläche 16 auf sowie eine der Montagefläche 16 gegenüberliegende Aufnahmefläche 17 zur Aufnahme eines LED-Halbleiterchips 13. Sowohl die Montagefläche 16 als auch die Aufnahmefläche 17 sind hochgenau bearbeitet.

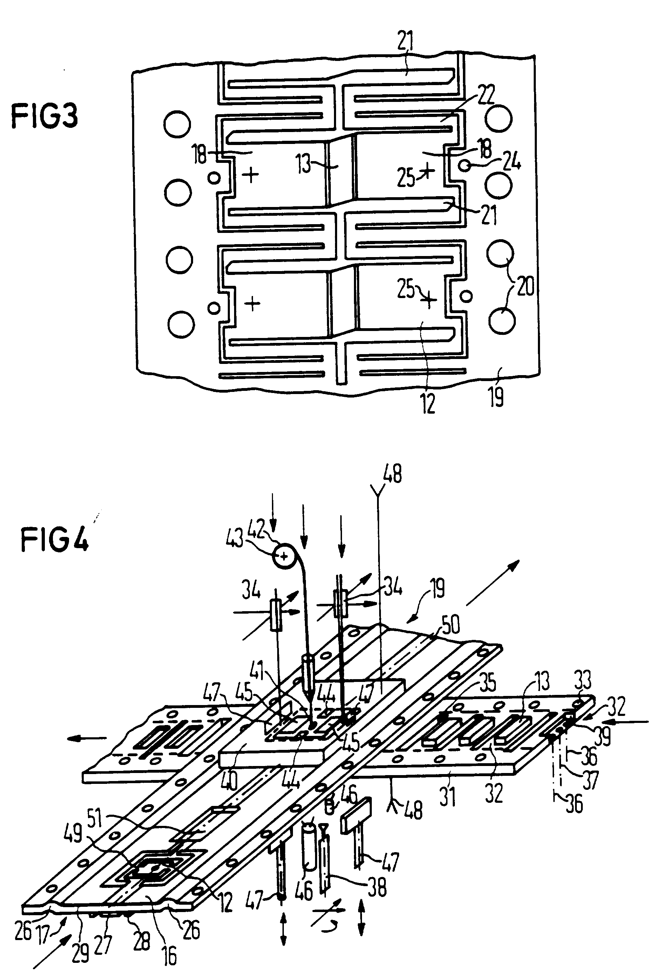

Ein weiteres Problem bei der Herstellung von derartigen Zeichengeneratoren besteht in der positionsgenauen Montage der Halbleiterelemente 13 auf dem Minimodulträger 12 im Positionsbereich der Minimodulträgermitte. Um diese Montage zu erleichtern, sind entsprechend den Figuren 2 und 3 die Minimodulträger 12 als Bereiche 18 eines bandförmigen Hilfsträgers 19 ausgebildet. Der bandförmige Hilfsträger besteht aus einem hochpräzisen Bandmaterial aus einer der Produktfunktion entsprechenden Legierung, z. B. Bronze oder Kupfer, d. h. aus einer Legierung, die geeignet ist, als Träger für die Chips zu dienen. Das Bandmaterial und damit der Minimodulträger 12 kann gegebenenfalls beschichtet, z. B. vernickelt oder vergoldet sein, wobei die Materialauswahl vom Anwendungsbereich abhängt, d. h. abhängig davon, ob das Minimodul zur Herstellung von Zeichengeneratoren, Scannern oder Thermokämmen verwendet wird. Auf jeden Fall muß das Bandmaterial bezüglich der Wärmeausdehnung, der Wärmeleitfähigkeit, des Wärmedurchganges, der elektrischen Leitfähigkeit, des Ionenübergangs in Richtung Chipmaterial und der verwendeten Verbindungstechnik wie Löten oder Kleben so ausgewählt werden, so daß es geeignet ist, bezüglich der herzustellenden und erforderlichen Ebenheit im Bereich der LED-Plazierung den hohen Ansprüchen des mechanischen Kontaktes zum Zeichengeneratorträger, d. h. zum Kühlträgerelement 10 zu genügen. Es muß außerdem leicht bearbeitbar sein.

Der bandförmige Hilfsträger 19 weist entsprechend den Darstellungen der Figur 2 und 3 seitliche Abtast- und Transportelemente 20 zur Führung und Positionierung des Hilfsträgers auf. Diese können aus Transportlochungen bestehen, die dazu dienen, den Hilfsträger im Bestückungsautomat zu transportieren. Den Abtast- und Transportelementen, in diesem Falle den Transportlochungen oder sonstigen Aussparungen für die Feinpositionierung, können Informationen über Prozeßdaten zugeordnet sein, derart, daß die Informationen über entsprechende Leseeinrichtungen in den Bestückungsautomaten gelesen werden können. Die Information kann dabei in der Perforationsteilung der Transportlochungen codiert gespeichert sein. Dies kann z. B. durch Variation des Abstandes der Transportlochungen in Abhängigkeit von der einzuspeichernden Information geschehen. Es ist außerdem möglich, Magnetstreifen oder Strichcodeelemente auf dem bandförmigen Hilfsträger 19 anzuordnen und diese Informationen dann mit entsprechenden Lesegeräten abzutasten, hierfür wird ein erforderlicher Platzbedarf auf dem Hilfsträger vorgesehen. Die gespeicherten Informationen können Informationen über die Folge der auf den Minimodulträgern 12 angeordneten Halbleiterchips sein sowie Informationen über deren Funktionsfähigkeit oder deren elektrische Kenngrößen.

Die Minimodulträger 12 sind auf dem bandförmigen Hilfsträger 19 relativ zum Hilfsträger allseitig auslenkbar angeordnet. Zu diesem Zwecke weist der bandförmige Hilfsträger 19 Ausnehmungen 21 auf, die den Minimodulträger 12 begrenzen und die derart ausgestaltet sind, daß eine kardanische Aufhängung der Minimodulträger im bandförmigen Hilfsträger 19 resultiert. Dies ermöglicht einen vereinfachten Vorrichtungsbau in der verarbeitenden Fertigungstechnik.

Eine derartige allseitige Auslenkbarkeit läßt sich entsprechend der Darstellung in Figur 3 auch dadurch erreichen, daß der Minimodulträger 12 in dem bandförmigen Hilfsträger 19 über mäanderförmig strukturierte Befestigungsflächen 22 aufgehängt sind. Die mäanderförmige Struktur wird ebenfalls durch Ausnehmungen 21 des bandförmigen Hilfsträgers 19 gebildet.

Die Ausnehmungen 21 des bandförmigen Hilfsträgers, die die Aufhängeelemente 22 für den Modulträger 12 begrenzen, können durch Stanzen des bandförmigen Hilfsträgers 19 erzeugt werden. Es ist jedoch auch möglich, hochpräzise Ätz- oder Feinstschneidetechniken, wie Laserschneiden oder dergleichen, zu verwenden.

Zur Erzeugung einer optimierten spannungsfreien Ebenheit des bandförmigen Hilfsträgers 19 kann der bandförmige Hilfsträger 19 nach dem Ausformen der Minimodulträger 12 bzw. der entsprechenden Bereiche 18 einer definierten Entspannung für eine erhöhte Ebenheit unter Temperatureinwirkung unterzogen werden. Damit kann es bei den nachfolgenden Verbindungsvorgängen zwischen Chip und Minimodulträger bzw. Minimodulträger und Trägerelement zu keinen Verformungen infolge Erhitzen kommen, wodurch sich kein gefährender Wärmestau beim Betreiben z. B. des Zeichengenerators einstellt.

Der bandförmige Hilfsträger 19 weist weiterhin bei einer Ausgestaltung entsprechend der Figur 2 zwei streifenförmige Klebeflächen 23 für ein hier nicht dargestelltes Elastomerelement auf, das im bestückten Zustand des bandförmigen Hilfsträgers 19 die LED-Chips 13 abdeckt, Bonddrähte schützt, Verschmutzungen abweist und Paketierungen (Stapelungen) erlaubt.

Weiterhin kann der bandförmige Hilfsträger 19 dem Bereich der Minimodulträger 12 bzw. dem Bereich 18 zugeordnete Öffnungen 24 aufweisen, in die bei der Bestückung entsprechende Positionierdorne eingreifen oder es können zusätzliche Positionierelemente 25 in Form von optischen Markierungen auf der Aufnahmefläche 17 (Bereich 18) des Minimodulträgers 12 (Figgur 3) angeordnet sein. Diese optischen Markierungen 25 können mit entsprechenden Abtasteinrichtungen oder Visionsystemen im Bestückungsautomat abgetastet werden.

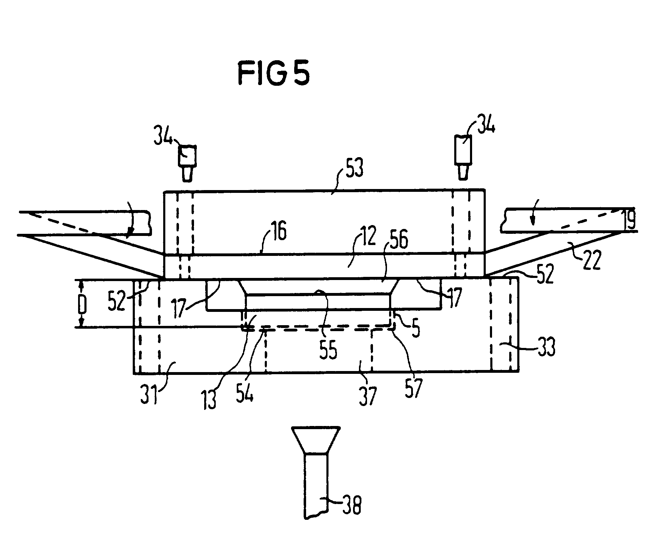

Um ein Verformen und Verwinden des bandförmigen Hilfsträgers 19 beim Handling in der Fertigung zu verhindern, kann der Hilfsträger 19 entsprechend der Darstellung der Figur 4 beidseitig zum Bereich 18 Versteifungssicken 26 aufweisen. Die Versteifungssicken 26 können durch einen Walzvorgang beim Hilfsträgerhersteller eingeprägt werden.

Mit Hilfe des beschriebenen bandförmigen Hilfsträgers 19 lassen sich die Halbleiterchips, Fototransistoren oder Thermoelemente in einfacher Weise auf einem Trägerelement 10 montieren. Zu diesem Zweck wird zunächst der bandförmige Hilfsträger 19 mit den darauf angeordneten Minimodulträgern 12 (Bereiche 18) hergestellt und zwar wie beschrieben aus einem hochpräzisen Bandmaterial mit einer hochpräzis bearbeiteten Unter- und Oberseite, die als Montagefläche 16 bzw. Aufnahmefläche 17 des Minimodulträgers 12 dient. Die Ausnehmungen 21 zur Begrenzung des allseitig auslenkbaren Minimodulträgers 12 können durch Ätzen des hochpräzisen Bandmaterials über entsprechende Masken erzeugt werden. Nach der Herstellung des bandförmigen Hilfsträgers 19 wird der bandförmige Hilfsträger 19 einem Bestückungsautomaten, wie er z. B. in der Figur 4 dargestellt ist, zugeführt und die Bereiche 18 (Figur 2, 3) d. h. die Minimodulträger des bandförmigen Hilfsträgers 19, werden auf ihrer Aufnahmefläche 17 mit Halbleiterchips bestückt.

Nach der Bestückung erfolgt der Transport des bestückten Hilfsträgers zu den Bonding und Prüfstationen. Dort kann wie bereits beschrieben, eine Informationszuordnung zu den einzelnen Minimodulen auf dem bandförmigen Hilfsträger 19 über deren Funktionsfähigkeit und gegebenenfalls über deren Position und Ansteuerung entweder durch Aufbringen eines Strichcodes oder eines anderen Codes oder durch Codierung über die Transportelemente 20 erfolgen.

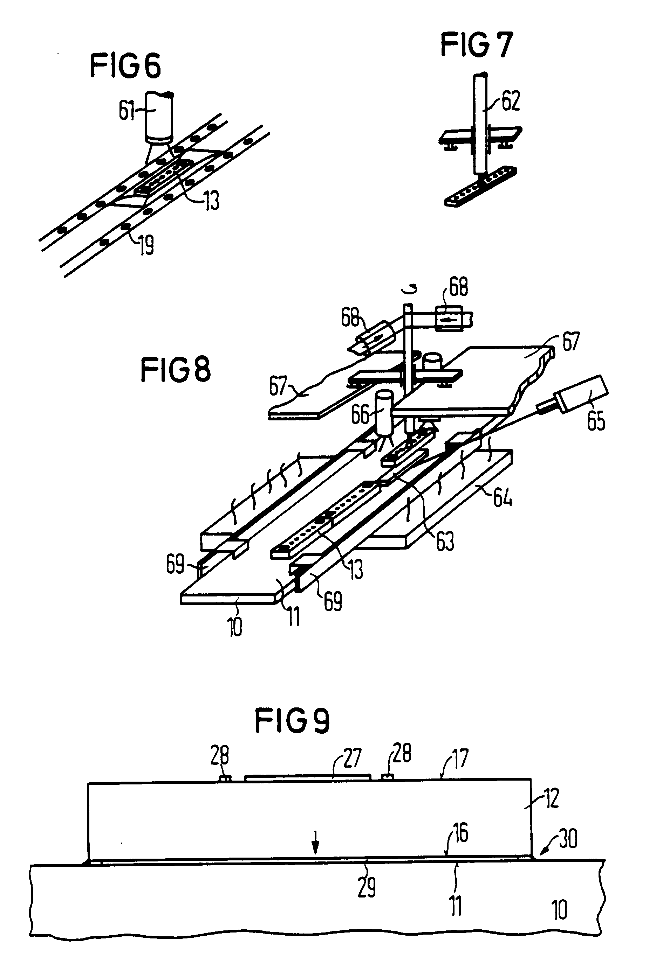

Nach der Codierung können die Minimodule auf dem Hilfsträger mit Hilfe eines auf den Klebeflächen 23 befestigten Elastomerbandes abgedeckt werden. Der fertig bestückte Hilfsträger kann nun in den eigentlichen Zeichengeneratorfertigungsbereich bzw. in den Fertigungsbereich für Scanner und Thermokämme verbracht werden. Mit Hilfe einer Bestückungseinrichtung, wie sie beispielsweise in den Figuren 6 bis 8 dargestellt ist, werden dann die Minimodulträger mit den darauf angeordneten Chips von dem Hilfsträger abgetrennt (lasern oder schneiden) und mit ihren Montageflächen auf der Paßfläche des Kühlträgerelementes 10 durch Löten oder Laserschweißen bzw. Kleben befestigt.

Um die Befestigung der Halbleiterchips auf den Minimodulträgern bzw. der Minimodulträger auf den Paßflächen der Trägerelemente zu erleichtern bzw. fehlerfrei sicherzustellen, kann der Minimodulträger 12 und damit der Hilfsträger 19 im Bereich 18 einen Aufbau entsprechend der Figur 9 haben. Auf der Aufnahmefläche 17 für die Halbleiterchips ist im Bereich der Halbleiterchips eine Metallschicht 27 aus Nickel-Gold bzw. Palladium angeordnet, die den Ionenübergang beim Löten behindert und den Lötvorgang fördert, sowie seitliche Begrenzungsstreifen 28 z.B. aus Aluminium als Lötstopsperre, die den Lötbereich auf der Aufnahmefläche 17 begrenzt und somit bei Einsatz von Schwallbädern und dergleichen eine Belötung der ebenfalls auf den dem Minimodulträger 12 angeordneten Ansteuerchips 14 verhindert. Statt den Begrenzungsstreifen 28 können auf dem Minimodul auch entsprechende Lotgräben in den Metallkörper eingebracht werden. Auf der Montagefläche 16 ist der Minimodulträger 12 und damit der Hilfsträger 19 mit einer galvanotechnischen Beschichtung 29 versehen und zwar ganz oder teilweise unterhalb der Fläche 27, die derart ausgestaltet ist, daß nach Befestigung der Montagefläche 16 auf der Paßfläche 11 des Trägerelementes 10 ein Bimetalleffekt auftritt oder eine bessere matallische Kontaktierung durch Kaltverschweißung, z. B. mit Gold, erwirkt wird. Damit wird bei Erwärmung ein sich verstärkender spezifischer Flächendruck im Bereich der Chips (Pfeil) erreicht. Ein derartiger Bimetalleffekt läßt sich erreichen, wenn man den Minimodulträger 12, der beispielsweise aus Kupfer besteht, im Bereich der Montagefläche 16 mit einer Metallschicht 29 versieht, die einen höheren Wärmeausdehnungskoeffizienten aufweist als Kupfer, z. B. Aluminium. Wird, wie in der Figur 9 dargestellt, der Minimodulträger 12 auf dem Trägerelement 10 mit Hilfe von Laserschweißen an den seitlichen Rändern 30 befestigt, so sorgt der Bimetalleffekt bei der Erwärmung dafür, daß sich der Minimodulträger 12 bei Erwärmung leicht nach unten (Pfeilrichtung) durchbiegt und so flächig und mit hoher Wärmeleitfähigkeit auf der Paßfläche 11 des Trägerelementes 10 aufliegt. Eine Vorverformung des Minimoduls mechanisch als Wippe verstärkt den Prozeß.

Zur Befestigung der vorgefertigten LED-Halbleiterchips 13 auf den Aufnahmeflächen 17 der Minimodulträger 12 des bandförmigen Hilfsträgers 19 kann eine Bestückungseinrichtung, wie sie in der Figur 4 dargestellt ist, verwendet werden. Bei der dargestellten Bestückungseinrichtung handelt es sich um eine LED-Bestückungsstation mit integrierter Löttechnik und Heizelementen zur Vorheizung von LED-Chipmagazinen auf Löttemperatur. Die Bestückungseinrichtung weist eine mehrachsige flexible und ansteuerbare Bestückungsmechanik auf mit Heiz- und Regelsystemen mit zugehöriger Bildauswerteeinrichtung sowie mit integrierten Wärmequellen für temperaturabhängige Verbindungstechniken. Bei der Bestückungseinrichtung erfolgt die Zufuhr der vorgefertigten LED-Halbleiterchips 13 über ein Chipmagazin 31 mit in dem Chipmagazin 31 angeordneten Vertiefungen 32 zur Aufnahme der Halbleiterchips, wobei die Halbleiterchips 13 mit der Montagefläche nach oben und ihrer Abstrahloberfläche nach unten gerichtet (face-down) in den Vertiefungen 32 angeordnet sind. Das Chipmagazin 31 weist weiterhin Transportelemente 33 zum automatischen Vorschub des Chipmagazines auf, sowie feinst bearbeitete Ober- und Unterflächen für die Führung und Antriebsmechanik im Flächenbereich der Bestückung um so -wie später erläutert- einen definierten Abstand zwischen der Montagefläche 16 des Minimodulträgers 12 und der Abstrahloberfläche des Halbleiterchips zu erzeugen, wobei mit Hilfe von Positionierdornen 34 bei dem Verbindungsvorgang eine Positionierung erfolgt. Die Positionierungsdorne 34 greifen dabei in entsprechende Positionieröffnungen 24 (Fig. 3) des bandförmigen Hilfsträgers 19 ein. Um die Durchführung von einer Schneidemechanik oder von Laserschweißelementen durch das Chipmagazin 31 gewährleisten zu können, weist das Chipmagazin 31 beidseitig der Vertiefungen 32 der einzelnen Chips, öffnungen 35 auf. Die Vertiefungen 32 enthalten an ihrem Boden Öffnungen 36 für Kameraoptiksysteme von unten zur Feinpositionierung der LED-Chips 13 auf, weiterhin einen Öffnungskanal 37 zur Feinpositionierung eines Fixier- und Halteelementes 38, das als Sauger für die LED-Chipfixierung ausgebildet ist und das durch den Öffnungskanal 37 von unten her die Halbleiterchips 13 erfaßt und positioniert. Die Kontur 39 der LED-Chipvertiefung 32 ist der Schnittkante des LED-Chips 13 angepaßt.

Die einzelnen in den Vertiefungen 32 des Chipmagazins 31 angeordneten Halbleiterchips 13 werden bei der dargestellten Ausführungsform dem, oberhalb des Magazins quer zur Transportrichtung des Magazins 31 verlaufenden, bandförmigen Hilfsträger 19 von unten her zugeführt. Der bandförmige Hilfsträger 19 liegt dabei mit seiner Montagefläche an der Stützfläche einer Minimodulspannvorrichtung 40 an. Die Minimodulspannvorrichtung 40 enthält in einer Ausführungsform einen Durchbruch 41 für die Lotzuführung mit zugeordneten Heizelementen für das Lot. Das Lot in Form von Lotfeindraht 42 kann dabei von oben über eine Lotdrahtspule 43 mit einer Lotvorschubeinheit zugeführt werden. Weiterhin enthält die Minimodulspannvorrichtung 40 Durchbrüche 44 für eine Kamera zur Feinpositionierung der Minimodule über Positionierdorne 34, gesteuert über Piezokeramikelemente. Die Kamera und die Endoskopietechnik ist hier nicht eingezeichnet, da gegebenenfalls die Anordnung der Kamera und der Endoskopietechnik weiter von der Einrichtung entfernt sein kann. Die Spannvorrichtung 40 weist außerdem noch integrierte Saugflächen 45 mit integriertem Saugkanal auf. Zur Steuerung des Positionsvorganges ist unterhalb des LED-Chipmagazins 31 eine Feinpositionierungsoptik 46 angeordnet, die mit den Öffnungen 36 im Chipmagazin zusammenwirkt und über diese Öffnungen 36 die Feinpositionierung der LED-Chips steuert bzw. kontrolliert. Ebenfalls in der Minimodulspannvorrichtung 40 geführt sind Cutter (Schneideeinrichtungen) 47 für die Verbindungselemente 22 (Fig. 3) der kardanischen bzw. mäanderförmigen Aufhängung des Minimoduls aus einer Streifenmechanik mit Niederhalter. Werden die kardanischen Aufhängungen 22 mit Hilfe von Laser getrennt, müssen entsprechende Öffnungen vorgesehen sein. Es ist dabei anzumerken, daß diese Schneideeinrichtungen nur dann in der Bestückungseinrichtung vorgesehen werden müssen, wenn die kardanischen oder mäanderförmigen Aufhängungen des Minimodulträgers 12 abgetrennt werden sollen. Eine derartige Abtrennung erfolgt normalerweise erst kurz vor der Bestückung des Trägerelementes 10 mit den abgetrennten Minimodulen. Es ist jedoch auch denkbar, die Minimodule bereits jetzt abzutrennen und sie durch entsprechende Abdeckfolien in den Öffnungen des bandförmigen Hilfsträgers 19 zu sichern.

Beheizt wird die ganze Einrichtung beim Löten mit einer von oben und unten wirkenden Heizung 48.

Um bei der Positionierung und dem Verlöten des Minimodulträgers 12 mit dem LED-Chip den Minimodulträger 12 sicher positionieren zu können, kann der Minimodulträger 13 gelöchterte Laschen 49 zum Feinpositionieren und Handling des Minimoduls bei der Lötung bzw. bei der Minimodulmontage auf dem Trägerelement 10 aufweisen. Weiterhin ist es möglich, auf der Montagefläche 16 des bandförmigen Hilfsträgers 19 eine geätzte Mittellinie 50 als Positionierhilfe für die Minimodule bei der Lötung vorzusehen, die über eine entsprechende Optik abgetastet wird. Es ist außerdem möglich, auf dem bandförmigen Hilfsträger 19 Freiräume 51 in Form eines Durchbruches vorzusehen, der als Druchbruch für eine LED-Chippositioniereinrichtung in der Bestückungsstation dienen kann, wenn z. B. anstelle eines LED-Chipmagazines 31 eine stationäre Vorrichtung verwendet wird.

Zur exakten Positionierung des Halbleiterchips gegenüber der Aufnahmefläche 17 und damit auch bezüglich der Montagefläche 16 beim Löt- und Verbindungsvorgang kann eine Anordnung gemäß der Figur 5 verwendet werden. Die Anordnung, die in der Bestückungseinrichtung der Figur 4 integriert sein kann, besteht wie in der Figur 5 im Querschnitt schematisch dargestellt, aus einer Stützfläche 52, die in dem dargestellten Ausführungsbeispiel auf den Seitenflächen des Chip-Magazins 31 angeordnet sind. Die Stützflächen 52 dienen als Anlageflächen für die Aufnahmefläche 17 des Minimodulträgers 12 beim Verbindungsvorgang. Während dieses Verbindungsvorganges drückt ein beweglicher Andruckstempel 53, der z. B. als bewegliche Heizplatte ausgebildet ist, den Minimodulträger 12 mit seiner Montagefläche 17 gegen die Stützflächen 52 des Chip-Magazins 31. Die Ränder des bandförmigen Hilfsträgers 19 verbleiben dabei in Position und der Minimodulträger 12 wird über seine elastischen Aufhängeelemente 22 durch die Bewegung der Heizplatte 53 ausgelenkt. Feinstellglieder 34 in Form von Positionierdornen positionieren den Minimodulträger 12 in einer exakten Lage. Uber die im Magazin angeordneten Öffnungen 37 wird über das Fixier- und Halteelement 38 das LED-Halbleiterchip 13 von unten her zugeführt und in einem Abstand D zwischen Aufnahmefläche 17 bzw. Stützfläche 32 und einer Bezugsfläche 54 positioniert. Die Bezugsfläche 54 wird durch die Abstrahloberfläche des LED-Chips gebildet. Der Abstand D ist nun so bemessen, daß sich zwischen der Aufnahmefläche 17 des Minimodulträgers 12 und der Rückseitenfläche 55 des Halbleiterchips 13 ein Spalt 56 zur Aufnahme des Verbindungswerkstoffes bildet.

Dadurch, daß das Chip 13 mit seiner Abstrahloberfläche 54 in einem Abstand D relativ zur Stützfläche 52 positioniert wird, werden über den Spalt Dickentoleranzen des Halbleiterchips ausgeglichen. Da außerdem der Minimodulträger 12 bezüglich seiner Montagefläche 16 exakt der Paßfläche 11 des Trägerelementes angepaßt ist, wird damit exakt der Abstand zwischen Paßfläche 11 des Trägerelementes 10 und der Abstrahloberfläche des Chips 13 eingehalten. Daraus resultiert im Endeffekt eine exakte Positionslage sämtlicher Abstrahloberflächen 54 der Halbleiterchips nach ihrer Montage auf dem Trägerelement über die Minimodulträger 12. Diese exakte Positionslage ist insbesondere bei der Verwendung von LED-Chips im Rahmen von Zeichengeneratoren bei elektrofotografischen Druck- oder Kopiergeräten notwendig, da die Abstrahloberflächen sich in dichtem Abstand zum sich bewegenden Fotoleiter befinden, bzw. dazwischen angeordnete Linsensysteme eine exakte Einhaltung des Abstandes erfordern.

Es ist jedoch festzustellen, daß jede beliebige Fläche des LED-Chips bedarfsweise als Bezugsfläche dienen kann. Z. B. auch die Unterseite, wenn es auf deren genaue Positionierung ankommt.

Der Saug- und Positioniergreifer 38 dient nicht nur zur exakten Positionierung des LED-Chips 13, sondern er überwindet auch Querbewegungen während des Verbindungsprozesses. Als Verbindungsmaterial im Spalt 55 kann flüssiges Lot, pastöses Lot oder Klebstoff verwendet werden. Die Fixierung der LED-Chips erfolgt formschlüssig durch Aussparungen 57 im Magazin 31, die mit den entsprechenden LED-Chipseitenkonturen zusammenwirken. Die Durchbrüche 33 im Chip-Magazin 31 dienen als Transportöffnungen, die mit entsprechenden Transportelementen in der Bestückungseinrichtung zusammenwirken.

Nach der Montage und Qualitätskontrolle durch Messungen können über Kennzeichnungen auf dem Hilfsträger 19 die auf dem Hilfsträger angeordneten Minimodule für die weitere Verarbeitung freigegeben werden. Um die Minimodule während einer Zwischenlagerung zu schützen, kann auf dem Hilfsträger 19 eine Elastomerband aufgebracht werden.

Zur automatischen Bestückung der Paßfläche 11 eines Trägerelementes 10 mit Minimodulen (Minimodulträgern 12 mit darauf angeordnetem Halbleiterchip 13) kann eine vollautomatische Bestückungseinrichtung entsprechend den Figuren 6 bis 9 verwendet werden. Mit Hilfe einer Kamera 61 (Figur 6) werden die auf dem bandförmigen Hilfsträger 19 angeordneten Minimodule 13 (Halbleiterchips) abgetastet und von einem Greifersystem mit Feinpositionierungsmechanik 62 von dem Hilfsträger 19 abgehoben. Dabei ist es notwendig, die kardanischen Aufhängungen des Minimodulträgers zu durchtrennen. Durch Verschwenken des Greifers 62, der eine Drehachsenpositioniermechanik aufweist, wird entsprechend der Figur 9, der Greifer und das von ihm festgehaltene Minimodul exakt auf der Paßfläche des Trägerelementes 10 positioniert. auf der Paßfläche 11 des Trägerelementes befindet.sich bereits Lot 63, z. B. in Form eines Lotbandes, das mit Hilfe einer sich an das Trägerelement 10 anschmiegenden Heizeinrichtung 64 vorgewärmt wird. Ein Laser 65 erwärmt die Paßfläche mit dem darauf angeordneten Lötband 65 im Bereich des Minimodulträgers bis zum Schmelzpunkt und sorgt so für eine exakte und lunkerfreie Verbindung zwischen Minimodulträger 12 und Paßfläche 11. Gesteuert und kontrolliert wird der Lötvorgang über ein Kamerasystem 66 für Meß- und Regeltechnik auf Referenzmaßstab zur definierten Teilung in X-Richtungund Y-Richtung zur Grob- und Feinpositionierung. Das zur Positionierung verwendete Greifersystem 62 orientiert sich in einer Anschlagfläche 67, wobei die Feinpositionierung über Piezokeramikelemente 68 erfolgt. Während des Verbindungsvorganges wird das Trägerelement 10 über Führungselemente 69 seitlich geführt.

### Bezugszeichenliste

- 10: Trägerelement, Kühlelement
- 11: Paßfläche
- 12: Minimodulträger
- 13: LED-Halbleiterchip
- 14: IC-Ansteuerschaltkreise
- 15: Gehäuse
- 16: Montagefläche
- 17: Aufnahmefläche
- 18: den Minimodulträgern entsprechende Bereiche des Hilfsträgers
- 19: bandförmige Hilfsträger
- 20: Transportelemente, Transportlochungen
- 21: strukturierte Ausnehmungen auf dem Hilfsträger
- 22: mäanderförmige Befestigungsflächen, Aufhängeelemente
- 23: Klebeflächen
- 24: öffnung
- 25: Positionierelement, Positioniermarkierungen
- 26: Versteifungssicke
- 27: Metallschicht
- 28: Begrenzungsstreifen, Lötstopsperre
- 29: galvanotechnische Beschichtung
- 30: seitliche Ränder
- 31: Chip-Magazin
- 32: Vertiefung
- 33: Transportelemente
- 34: Positionierdorne
- 35: Öffnungen, Durchführungen
- 36: Öffnungen, Optik
- 37: Öffnungskanal, Durchgangsöffnung
- 38: Fixier- und Haltelement
- 39: Kontur der LED-Chipvertiefung
- 40: Minimodul-Spannvorrichtung
- 41: Durchbruch
- 42: Lotfeindraht
- 43: Lotdrahtspule
- 44: Durchbruch
- 45: integrierte Saugflächen
- 46: Feinpositionierungsoptik
- 47: Cutter, Schneideeinrichtung, Andruckeinrichtung
- 48: Heizung
- 49: gelochte Laschen
- 50: geätzter Mittelstreifen, Positionierhilfe
- 51: Freiräume
- 52: Stützflächen
- 53: Andruckelement
- 54: Bezugsfläche, Abstrahloberfläche
- D: Abstand
- 55: Rückseitenfläche, Befestigungsfläche
- 56: Spalt
- 57: Aussparungen
- 58: Durchbrüche
- 61: Kamera
- 62: Greifer
- 63: Lotband
- 64: Heizeinrichtung
- 65: Laser
- 66: Kamerasystem
- 67: Anschlagfläche
- 68: Piezokeramikelemente, Betätigungselemente
- 69: Führungselemente

## Patentansprüche

1. Bandförmiger Hilfsträger (19) als Montagehilfe für die zeilenweise Montage von Halbleiterchips (13) auf einer Paßfläche (11) eines Trägerelementes (10), insbesondere zur Herstellung von Zeichengeneratoren für nach dem Umdruckverfahren arbeitende Drucker, Kopierer oder zur Herstellung von Scannern bzw. Thermokämmen
mit
- Minimodulträgern (12), die auf dem Hilfsträger (19), relativ zum Hilfsträger (19) allseitig auslenkbar, angeordnet sind und die eine Montagefläche (16) und eine der Montagefläche (16) gegenüberliegende Aufnahmefläche (17) zur Aufnahme der Chips (13) aufweisen und
- mit Abtast- und Transportelementen (20) zur Führung und Positionierung des Hilfsträgers (19).

2. Bandförmiger Hilfsträger nach Anspruch 1 mit
- einer der Montagefläche (16) zugeordneten galvanotechnischen Beschichtung (29), die derart ausgestaltet ist, daß nach der Befestigung des Minimodulträgers (12) mit seiner Montagefläche (16) auf der Paßfläche (11) des Trägerelementes (10) ein Verformungseffekt auftritt, der bei Erwärmen einen sich verstärkenden spezifischen Flächendruck des Minimodulträgers (12) auf die Paßfläche (11) des Trägerelementes (10) bewirkt.

3. Bandförmiger Hilfsträger nach einem der Ansprüche 1 oder 2 mit
- einer der Aufnahmefläche (17) zugeordneten Metallisierungsschicht (27) aus einem dem Ionenübergang behindernden und einen Lötvorgang fördernden Material.

4. Bandförmiger Hilfsträger nach Anspruch 3 mit
- einer einen Lötbereich auf der Aufnahmefläche (17) begrenzenden Lötstopsperre (28) aus einer Lötmaterial abweisenden Materialschicht.

5. Bandförmiger Hilfsträger nach einem der Ansprüche 1 bis 4 mit Abtast- und Transportelementen (20), denen Informationen über Prozeßdaten zugeordnet sind, derart, daß die Informationen über die Abtast- und Transportelemente ausgelesen werden können.

6. Bandförmiger Hilfsträger nach Anspruch 5 mit
- als Transportlochungen (20) ausgebildeten Abtast- und Transportelementen mit einer vorgebbaren Perforationsteilung als Informationsträger für die Prozeßdaten.

7. Bandförmiger Hilfsträger nach einem der Ansprüche 1 bis 6 mit
- dem Hilfsträger (29) einschließlich dem Minimodulträger (12) zugeordneten Positionier- und Handlingskonturen (49) als Greif- und Positionierflächen für die bei einer automatisierten Verarbeitung erforderlichen Greif- und Positionierelemente.

8. Bandförmiger Hilfsträger nach Anspruch 7 mit
- einer auf dem Hilfsträger angeordneten Positionierlinie (50) als abtastbare Positionierhilfe für die Positionierung der Minimodulträger.

9. Bandförmiger Hilfsträger nach einem der Ansprüche 1 bis 8 mit einem
- Minimodulträger (12), der durch Ausnehmungen (21) des bandförmigen Hilfsträgers (19) begrenzt ist, wobei die Ausnehmungen (21) derart ausgestaltet sind, daß eine kardanische Aufhängung des Minimodulträgers (12) im Hilfsträger (19) resultiert.

10. Bandförmiger Hilfsträger nach einem der Ansprüche 1 bis 8 mit einem
- Minimodulträger (12), der in dem Hilfsträger (19) über mäanderförmig strukturierte Befestigungsflächen (22) aufgehängt ist, wobei die mäanderförmige Struktur durch Ausnehmungen (21) des Hilfsträgers gebildet wird.

11. Bandförmiger Hilfsträger nach einem der Ansprüche 1 bis 10 mit
- einer Klebefläche (23) für ein Elastomerelement zur Abdekkung der bestückten Minimodulträger.

12. Bandförmiger Hilfsträger nach einem der Ansprüche 1 bis 11 mit
- einer im Bereich der Transportelemente angeordneten Versteifungsstruktur (26).

13. Bandförmiger Hilfsträger nach einem der Ansprüche 1 bis 12, der aus hochpräzisem Bandmaterial aus einer der Produktfunktion entsprechenden Legierung aufgebaut ist, wobei zur Erzeugung einer optimierten, spannungsfreien Ebenheit des Hilfsträgers (19) der Hilfsträger (19) einer künstlichen Temperung unterzogen wird.

14. Verfahren zur zeilenweise Montage von Halbleiterchips (13) auf einer Paßfläche (11) eines Trägerelementes (10), insbesondere zur Herstellung von Zeichengeneratoren für nach dem Umdruckverfahren arbeitende Drucker, Kopierer oder zur Herstellung von Scannern bzw. Thermokämmen mit folgenden Verfahrensschritten:
a) Positionieren und Befestigen der Halbleiterchips (13) auf Minimodulträgern (12) eines bandförmigen Hilfsträgers (19), wobei
a1) die Minimodulträger (12) auf dem Hilfsträger (19) relativ zum Hilfsträger allseitig auslenkbar ausgebildet sind, mit einer Montagefläche (16) und einer der Montagefläche (16) gegenüberliegenden Aufnahmefläche (17) zur Aufnahme der Chips (13),
b) Abtrennen der Minimodulträger (12) mit den darauf angeordneten Chips (13) von dem Hilfsträger (19) und Positionieren und Befestigen der Minimodulträger (12) mit ihrer Montagefläche (16) auf der Paßfläche (11) des Trägerelementes (10).

15. Verfahren nach einem der Ansprüche 14, wobei die Minimodulträger (12) durch Löten auf den Paßflächen (11) der Trägerelemente befestigt werden.

16. Verfahren nach einem der Ansprüche 14 oder 15, wobei die toleranzbestimmenden Konturkanten der Minimodulträger (12) durch hochpräzise Techniken, insbesondere Lasern oder Foto-bzw. Ätztechnik erzeugt werden.

17. Verfahren nach Anspruch 14, wobei zum Positionieren und Befestigen der Halbleiterchips (13) auf den Minimodulträgern (12)
c) der Hilfsträger (19) derart geführt wird, daß die Aufnahmeflächen (17) der Minimodulträger (12) für die Chips (13) nach unten gerichtet sind;
c1) die Minimodulträger (12) über eine Betätigungseinrichtung (53) aus dem Hilfsträger (19) ausgelenkt werden, so daß sie sich mit ihrer Aufnahmefläche (17) auf einer Stützfläche (52) abstützen;
c2) die Halbleiterchips (13) über ein unterhalb des Hilfsträgers (19) angeordnetes Magazin (31) zugeführt werden und
c3) Greifelemente (38) die Halbleiterchips (13) erfassen und im Bereich der Aufnahmeflächen (17) der Minimodulträger (12) in einen vorgegebenen Abstand (D) zwischen der Aufnahmefläche (17) und einer Bezugsfläche des Chips (13) positionieren derart, daß sich zwischen einer Befestigungsfläche (55) des Chips (13) und der Aufnahmefläche (17) ein toleranzausgleichender Spalt zur Aufnahme eines Verbindungswerkstoffes bildet.

18. Verfahren nach Anspruch 17, wobei die Stützflächen (52) als Flächen des Magazins (31) ausgebildet sind.

## Claims

1. Auxiliary carrier (19) in the form of a strip and used as a mounting aid for the mounting of semiconductor chips (13) in lines on a fitting surface (11) of a carrier element (10), in particular for the production of character generators for printers operating in accordance with the transfer printing process, copiers or for the production of scanners or thermal combs, having
- miniature module carriers (12), which are arranged on the auxiliary carrier (19) such that they can be displaced on all sides relative to the auxiliary carrier (19), and which have a mounting surface (16) and an accommodating surface (17) which is opposite to the mounting surface (16) and is intended for accommodating the chips (13), and
- scanning and transport elements (20) for guiding and positioning the auxiliary carrier (19).

2. Auxiliary carrier in the form of a strip according to Claim 1, having
- an electroplated coating (29) which is assigned to the mounting surface (16) and is configured in such a way that, after the miniature module carrier (12) is secured by its mounting surface (16) on the fitting surface (11) of the carrier element (10), a deformation effect occurs which, in the event of heating, brings about an intensifying, specific surface pressure of the miniature module carrier (12) on the fitting surface (11) of the carrier element (10).

3. Auxiliary carrier in the form of a strip according to one of Claims 1 and 2, having
- a metallization layer (27) which is assigned to the accommodating surface (17) and is made of a material which hinders the ion transfer and promotes a soldering operation.

4. Auxiliary carrier in the form of a strip according to Claim 3, having
- a solder resist barrier (28) which delimits a soldering region on the accommodating surface (17) and is made of a material layer which rejects soldering material.

5. Auxiliary carrier in the form of a strip according to one of Claims 1 to 4, having scanning and transport elements (20) to which information concerning process data are assigned, in such a way that the information can be read out via the scanning and transport elements.

6. Auxiliary carrier in the form of a strip according to Claim 5, having
- scanning and transport elements which are designed as transport perforations (20) and have a predeterminable perforation pitch, as information media for the process data.

7. Auxiliary carrier in the form of a strip according to one of Claims 1 to 6, having
- positioning and handling contours (49) which are assigned to the auxiliary carrier (29), including the miniature module carrier (12), and are used as gripping and positioning surfaces for the gripping and positioning elements which are necessary in automated processing.

8. Auxiliary carrier in the form of a strip according to Claim 7, having
- a positioning line (50) which is arranged on the auxiliary carrier and is used as a scannable positioning aid for the positioning of the miniature module carriers.

9. Auxiliary carrier in the form of a strip according to one of Claims 1 to 8, having a
- miniature module carrier (12) which is delimited by recesses (21) in the auxiliary carrier (19) in the form of a strip, the recesses (21) being configured so as to result in a cardanic suspension of the miniature module carrier (12) in the auxiliary carrier (19).

10. Auxiliary carrier in the form of a strip according to one of Claims 1 to 8, having a
- miniature module carrier (12) which is suspended in the auxiliary carrier (19) by means of securing surfaces (22) having a meandering structure, the meandering structure being formed by recesses (21) in the auxiliary carrier.

11. Auxiliary carrier in the form of a strip according to one of Claims 1 to 10, having
- an adhesive surface (23) for an elastomer element for covering the populated miniature module carriers.

12. Auxiliary carrier in the form of a strip according to one of Claims 1 to 11, having
- a reinforcing structure (26) arranged in the region of the transport elements.

13. Auxiliary carrier in the form of a strip according to one of Claims 1 to 12, which is constructed from high-precision strip material made of an alloy corresponding to the product function, the auxiliary carrier (19) being subjected to artificial tempering in order to produce optimized, stress-free evenness of the auxiliary carrier (19).

14. Method for the mounting of semiconductor chips (13) in lines on a fitting surface (11) of a carrier element (10), in particular for the production of character generators for printers operating in accordance with the transfer printing process, copiers or for the production of scanners or thermal combs, having the following method steps:
a) positioning and securing the semiconductor chips (13) on miniature module carriers (12) of an auxiliary carrier (19) in the form of a strip,
a1) the miniature module carriers (12) on the auxiliary carrier (19) being designed such that they can be displaced on all sides relative to the auxiliary carrier, having a mounting surface (16) and an accommodating surface (17) which is opposite to the mounting surface (16) and is intended for accommodating the chips (13),
b) separating the miniature module carriers (12) with the chips (13) arranged thereon from the auxiliary carrier (19) and positioning and securing the miniature module carriers (12) by their mounting surface (16) on the fitting surface (11) of the carrier element (10).

15. Method according to Claim 14, the miniature module carriers (12) being secured on the fitting surfaces (11) of the carrier elements by soldering.

16. Method according to one of Claims 14 and 15, the tolerance-determining contour edges of the miniature module carriers (12) being produced by means of high-precision techniques, in particular the use of lasers or a photographic or etching technique.

17. Method according to Claim 14, for the purpose of positioning and securing the semiconductor chips (13) on the miniature module carriers (12):
c) the auxiliary carrier (19) being guided in such a way that the accommodating surfaces (17) of the miniature module carriers (12) for the chips (13) are face down;
c1) the miniature module carriers (12) being displaced from the auxiliary carrier (19) by means of an actuation device (53), with the result that they are supported by their accommodating surface (17) on a supporting surface (52);
c2) the semiconductor chips (13) being fed via a magazine (31) arranged beneath the auxiliary carrier (19), and
c3) gripping elements (38) seizing the semiconductor chips (13) and positioning them in the region of the accommodating surfaces (17) of the miniature module carriers (12) at a predetermined distance (D) between the accommodating surface (17) and a reference surface of the chip (13), in such a way that a tolerance-cowpensating gap for receiving a connecting material is formed between a securing surface (55) of the chip (13) and the accommodating surface (17).

18. Method according to Claim 17, the supporting surfaces (52) being designed as surfaces of the magazine (31).

## Revendications

1. Support auxiliaire (19) en forme de bande servant d'aide pour le montage ligne par ligne de puces à semi-conducteur (13) sur une surface de contact (11) d'un élément porteur (10), notamment pour la fabrication de générateurs de caractères pour des imprimantes, des copieurs fonctionnant selon le procédé de duplication ou pour la fabrication de scanners ou bien de thermopeignes comportant
- des supports de mini-modules (12), qui sont disposés sur le support auxiliaire (19), tout en pouvant être éloignés dans toutes les directions par rapport au support auxiliaire (19), et qui présentent une surface de montage (16) et une surface réceptrice (17) opposée à la surface de montage (16) pour le logement des puces (13) et comportant des éléments capteurs et d'entraînement (20) pour le guidage et le positionnement du support auxiliaire (19).

2. Support auxiliaire en forme de bande selon la revendication 1 comportant
- un revêtement galvanique (29) associé à la surface de montage (16), qui est configuré de telle sorte qu'après la fixation du support de mini-modules (12) avec sa surface de montage (16) sur la surface de contact (11) de l'élément porteur (10) apparaît un effet de déformation, qui, en chauffant, exerce une pression superficielle spécifique croissante du support de mini-modules sur la surface de contact (11) de l'élément porteur (10).

3. Support auxiliaire en forme de bande selon l'une des revendications 1 ou 2 comportant
- une surface de métallisation (27), composée d'une matière qui empêche le passage des ions et demande un processus de soudure, associée à la surface réceptrice (17).

4. Support auxiliaire en forme de bande selon la revendication 3 comportant
- un arrêt de soudure (28), composé d'une couche de matière repoussant le matériau de soudure, qui limite une zone de soudure sur la surface réceptrice (17).

5. Support auxiliaire en forme de bande selon l'une des revendications 1 à 4, comportant des éléments capteurs et d'entraînement (20), auquels sont associées des informations sur les données des opérations de telle sorte que les informations peuvent être lues par l'intermédiaire des éléments capteurs et d'entraînement.

6. Support auxiliaire en forme de bande selon la revendication 5 comportant
- des éléments d'entraînement et capteurs conçus comme des perforations d'entraînement (20) avec un pas de perforation pouvant être prédéfini, servant de support d'information pour les données des opérations.

7. Support auxiliaire en forme de bande selon l'une des revendications 1 à 6 comportant
- des contours de positionnement et de maniement (49) associés au support auxiliaire (29) y compris au support de mini-modules (12) servant de surfaces de saisie et de positionnement pour les éléments de griffe et de positionnement nécessaires lors d'une transformation automatisée.

8. Support auxiliaire en forme de bande selon la revendication 7 comportant
- une ligne de positionnement (50) disposée sur le support auxiliaire servant d'auxiliaire de positionnement détectable pour le positionnement des supports de mini-modules.

9. Support auxiliaire en forme de bande selon l'une des revendications 1 à 8 comportant un
- support de mini-modules (12), qui est limité par des évidements (21) du support auxiliaire en forme de bande (19), les évidements (21) étant configurés de telle sorte qu'il en résulte une suspension à la Cardan du support de mini-modules (12) dans le support auxiliaire (19).

10. Support auxiliaire en forme de bande selon l'une des revendications 1 à 8 comportant un
- support de mini-modules (12) qui est suspendu dans le support auxiliaire (19) par l'intermédiaire de surfaces de fixation (22) ayant une structure en forme de méandres, la structure en forme de méandres étant formée par des évidements (21) du support auxiliaire.

11. Support auxiliaire en forme de bande selon l'une des revendications 1 à 10 comportant
- une surface de collage (23) pour un élément élastomère destiné à couvrir les supports de mini-modules équipés.

12. Support auxiliaire en forme de bande selon l'une des revendications 1 à 11 comportant
- une structure de renforcement (26) disposée dans la zone des éléments d'entraînement.

13. Support auxiliaire en forme de bande selon l'une des revendications 1 à 12, qui est constitué d'un matière en bande de grande précision réalisée à partir d'un alliage correspondant à la fonction du produit, le support auxiliaire (19) étant soumis à un recuit artificiel pour produire une planitude optimisée, exempte de tension du support auxiliaire (19).

14. Procédé pour le montage ligne par ligne de puces à semi-conducteur (13) sur une surface de contact (11) d'un élément porteur (10), notamment pour la fabrication de générateurs de caractères pour des imprimantes, copieurs fonctionnant selon le procédé de duplication ou pour la fabrication de scanners ou bien de thermopeignes comportant les étapes de procédé suivantes :
a) positionnement et fixation des puces à semi-conducteur (13) sur des supports de mini-modules (12) d'un support auxiliaire (19) en forme de bande, a1) les supports de mini-modules (12) étant conçus sur le support auxiliaire (19) tout en pouvant être éloignés dans toutes les directions par rapport au support auxiliaire, avec une surface de montage (16) et une surface réceptrice (17) opposée à la surface de montage (16) pour le logement des puces (13), b) séparation des supports de mini-modules (12) comportant les puces (13) disposées dessus, du support auxiliaire (19) et positionnement et fixation des supports de mini-modules (12) par leur surface de montage (16) sur la surface de contact (11) de l'élément porteur (10).

15. Procédé selon la revendication 14, les supports de mini-modules (12) étant fixés par soudage sur les surfaces de contact (11) des éléments porteurs.

16. Procédé selon l'une des revendications 14 ou 15, les bords des contours des supports de mini-modules (12) définissant la tolérance étant produits par des techniques de grande précisions, en particulier par une technique de laser ou une technique de photogravure, resp. de gravure chimique.

17. Procédé selon la revendication 14, dans lequel pour le positionnement et la fixation des puces à semi-conducteur (13) sur les supports de mini-modules (12)
c) le support auxiliaire (19) est guidé de telle sorte que les surfaces réceptrices (17) des supports de mini-modules (12) pour les puces (13) sont orientées vers le bas ;
c1) les supports de mini-modules (12) sont éloignés du support auxiliaire (19) par l'intermédiaire d'un système de commande (53), de sorte qu'ils s'appuient par leur surface réceptrice (17) sur une surface d'appui (52) ;
c2) les puces à semi-conducteur (13) sont amenées par l'intermédiaire d'un magasin (31) disposé au-dessous du support auxiliaire (19) et
c3) des éléments de griffe (38) saisissent les puces à semi-conducteur (13) et les positionnent dans la zone des surfaces réceptrices (17) des supports de mini-modules (12) selon un intervalle (D) prédéfini entre la surface réceptrice (17) et une surface de référence de la puce (13) de telle sorte que se forme une fente compensant la tolérance, destinée au logement d'une matière d'assemblage, entre une surface de fixation (55) de la puce (13) et la surface réceptrice (17).

18. Procédé selon la revendication 17, les surfaces d'appui (52) étant conçues comme des surfaces du magasin (31).
